# EUROPÄISCHE PATENTSCHRIFT

(11) **EP 1 330 558 B1**
(45) Veröffentlichungstag und Bekanntmachung des Hinweises auf die Patenterteilung: **03.01.2007**
(21) Anmeldenummer: 01988508.6
(22) Anmeldetag: 25.10.2001
(51) Int. Cl.: C23C 18/32, C23C 18/36

(54) **BLEIFREIE CHEMISCH-NICKEL-LEGIERUNG**
LEADFREE CHEMICAL NICKEL ALLOY
ALLIAGE DE NICKEL OBTENU CHIMIQUEMENT, EXEMPT DE PLOMB

(30) Priorität: 25.10.2000 DE 10052960
(43) Veröffentlichungstag der Anmeldung: 30.07.2003
(73) Patentinhaber: AHC-Oberflächentechnik GmbH & Co. OHG, 50171 Kerpen (DE)
(72) Erfinder: HOLLÄNDER, Alfons, 50170 Kerpen-Buir (DE); BECKER, Heinz-Peter, 50171 Kerpen (DE)
(74) Vertreter: Dunkelberg, Oliver Thomas Michael
(86) Internationale Anmeldenummer: PCT/DE2001/004014
(87) Internationale Veröffentlichungsnummer: WO 2002/034964

(56) Entgegenhaltungen:
- GB-A- 845 648
- PATENT ABSTRACTS OF JAPAN vol. 018, no. 429 (P-1785), 10. August 1994 (1994-08-10) & JP 06 131659 A (C UYEMURA & CO LTD), 13. Mai 1994 (1994-05-13) & JP 06 131659 A 13. Mai 1994 (1994-05-13)

## Beschreibung

Die vorliegende Erfindung betrifft eine bleifreie, chemisch, d.h. außen stromlos erzeugte Nickellegierung, ein Verfahren zur Erzeugung einer solchen Nickellegierung durch stromlose Metallabscheidung in einem wäßrigen Elektrolyten sowie damit beschichtete Gegenstände.

Die außen stromlose chemische Vernickelung von Metalloberflächen ist ein im industriellen Maßstab häufig angewandtes Verfahren zum Korrosionsschutz von Metallen.
Zwecks Erzielen eines verbesserten Korrosionsschutzes hat es sich als notwendig erwiesen, durch Zusatz geeigneter Verbindungen zum wäßrigen Elektrolyten eine Nickel/Phosphorlegierung zu erreichen.
Reine Nickel und phosphinathaltige Elektrolyte für chemische Vernickelungen benötigen zur Verhinderung einer Spontanzersetzung zusätzlich Stabilisatoren. Eine für die industrielle Applikation ausreichende Stabilisierung wurde bislang nur durch den Zusatz von Bleiverbindungen erreicht. Bisher alternativ zugesetzte Stabilisatoren, wie beispielsweise Molybdän-, Cadmium oder Zinnverbindungen, zeigen im Vergleich zum Blei eine unzureichende Wirkungsweise.
Jedoch genügt auch eine solch modifizierte Chemisch-Nickel-Schicht nicht den gesteigerten Anforderungen in bezug auf die Korrosionsbeständigkeit, wie sie beispielsweise in der Elektronikindustrie bei der Herstellung gedruckter Schaltungen existieren.
Der Zusatz von Blei hat jedoch den Nachteil, dass bei einer Überschreitung des Sollwerts der Bleikonzentration zunehmend eine Kantenpassivität zu beobachten ist. Hierunter versteht man, dass an Kanten von Bauteilen ein verringerter Schichtaufbau zu beobachten ist. Dies bewirkt eine verschlechterte Korrosionsbeständigkeit in den entsprechenden Bereichen.
Dieses Problem ist besonders an den innerenRandbereichen von Bohrungen bei gedruckten Schaltungen zu beobachten, wodurch die elektrischen Eigenschaften von Löt- und/oder Bondingverbindungen nachhaltig verschlechtert werden.
Darüber hinaus ist der Zusatz von Blei aus umweltpolitischen Gesichtspunkten nicht mehr zu vertreten; die resultierende Anwesenheit von Blei in gedruckten Schaltungen verhindert eine umweltgerechte Entsorgung der entsprechenden Leiterplatten.

Ein Elektrolyt zur Herstellung bleifreier, außen stromlos erzeugter Nickelschichten ist aus der US 2 884.344 bekannt Entsprechend dem dort beschriebenen Verfahren werden dem Elektrolyten mindestens zwei Kationen hinzugefügt, ausgewählt aus der Gruppe von Antimon, Arsen und Bismut. Dabei beträgt die Konzentration an Antimon- und Bismutionen mindestens 5 ppm bei einem Verhältnis zwischen Antimon zu Bismut zwischen 1 : 5 und 1 : 0,5.
Die entsprechend diesem Verfahren erzeugten Schichten weisen in der Nickellegierung einen Anteil an Bismut von mindestens 0,5 Gew.-% und einen Anteil an Antimon von höchstens 0,1 Gew.-% aller Bestandteile der Nickellegierung auf, haben eine matte Oberfläche, zeigen eine ausgeprägte Zugeigenspannung und weisen eine unzureichende Korrosionsbeständigkeit auf.

Aufgabe der vorliegenden Erfindung ist die Bereitstellung einer Chemisch-Nickel-Schicht, die kein Blei enthält, druckeigenspannungsbehaftet ist und gleichzeitig eine ausreichend hohe Korrosionsbeständigkeit aufweist, so daß sie in der Elektronikindustrie bei der Herstellung gedruckter Schaltungen verwendet werden kann.
Eine weitere Aufgabe dieser Erfindung ist die Bereitstellung eine Verfahrens, mit dem im industriellen Maßstab eine solche Schicht erzeugt werden kann, ohne dass sich der bleifreie Elektrolyt zersetzt.

Die erste Aufgabe wird gelöst durch eine sich auf einer metallischen Substratoberfläche befindliche bleifreie Nickellegierung, enthaltend
- Nickel,
- Phosphor,
- Bismut mit einem Anteil von höchstens 0,4 Gew.-%, und
- Antimon mit einem Anteil von mindestens 1 Gew.-%,
wobei sich die Gew.-% auf alle genannten Bestandteile der Nickellegierung beziehen, d.h. auf die in der Legierung befindlichen Elemente Nickel, Phosphor, Bismut und Antimon.

Unter dem Begriff "metallische Substratoberfläche" werden auch Kunststoffoberflächen verstanden, die zuerst anhand von dem Fachmann bekannten Verfahren aktiviert und anschließend vernickelt werden.

Mit dem erfindungsgemäßen Verfahren ist es erstmals möglich, eine bleifreie Nickellegierung bereit zu stellen, die im Vergleich mit herkömmlichen Nickel/Phosphorschichten druckeigenspannungsbehaftet ist, eine deutlich verbesserte Korrosionsbeständigkeit und gleichzeitig einen hohen Glanzgrad aufweist.

Durch die Kombination von Bismut und Antimon wird darüber hinaus ein synergistischer Effekt erzielt: Das Fehlen von Antimon in der resultierenden Nickellegierung würde innere Spannungen verursachen, die wiederum eine verschlechterte Korrosionsbeständigkeit mit sich brächte. Ohne Bismut wäre die Gesamtstabilität des Elektrolyten unzureichend, was anhand von Spontanzersetzungen des Elektrolyten zu beobachten wäre.

Durch Kombination dieser beiden Elemente wird sowohl die Korrosionsbeständigkeit als auch die Stabilität des Elektrolyten messbar erhöht.

Eine übliche Schichtdicke dieser Nickellegierung zwischen 2 und 50 µm reicht für die Korrosionsbeständigkeit aus. Es können aber auch Schichtdicken mit mehr als 100 µm im Wege geeigneter Verfahren erreicht werden.
Eine Schichtdicke von mehr als 40 µm ergibt eine Beständigkeit der Stufe 4 der sehr starken Korrosionsbeanspruchung nach DIN 50 966. Dies ist insbesondere für die Beschichtung von Hydraulikzylindern von besonderer Bedeutung.

Als Substrat können alle geeigneten Metalle oder deren Legierungen verwendet werden, Im Hinblick auf die Umweltproblematik in bezug auf bleihaltige Nickelschichten findet die erfindungsgemäße Nickellegierung besonders als Korrosionsschutz und Diffusionssperre in der Elektronikindustrie bei der Herstellung von Leiterplatten Anwendung.

Der Anteil an Phosphor in der resultierenden Nickellegierung kann zwischen 2 und 15 Gew.-% aller Bestandteile der Nickellegierung liegen, bezogen auf alle Bestandteile der Nickellegierung, d.h. auf die in der entstandenen Legierung enthaltenden Elemente Nickel, Phosphor, Bismut und Antimon.
Der Anteil an Bismut kann zwischen 0,01 und 0,2 Gew.-% aller Bestandteile der Nickellegierung liegen.

Eine bevorzugte Ausführungsform der erfindungsgemäßen Nickellegierung wird erreicht, wenn die Bestandteile Nickel, Phosphor, Bismut und Antimon gleichmäßig in der Legierungsschicht verteilt sind. Der Begriff "gleichmäßig" bedeutet hier und im folgenden eine legierungstypische Verteilung der entsprechenden Elemente in der Nickelmatrix. Durch diese gleichmäßige Verteilung wird ein einheitliches Gefüge in der Legierung erreicht, so daß die mechanischen und elektrischen Eigenschaften dieser Schicht auch in engen Toleranzbereichen konstant sind, was besonders für die Elektronikindustrie im Rahmen der dort üblichen Qualitätssicherung von besonderer Bedeutung ist.

Die zweite Aufgabe der Erfindung wird gelöst durch ein Verfahren, wobei ein metallisches Substrat in einen wäßrigen Elektrolyten getaucht wird, und der wässrige Elektrolyt Nickelkationen, Phosphinationen, Bismutionen in einer Konzentration an Bismut von höchstens 0,3 ppm und Antimonionen in einer Konzentration an Antimon von mindestens 10 ppm, bezogen auf den Elektrolyten, enthält.

Die einzelnen Verfahrensschritte zur Herstellung einer chemisch erzeugten Nickellegierung durch außen stromlose Metallabscheidung in einem wäßrigen Elektrolyten sind prinzipiell bekannt. Dies gilt insbesondere für die Wahl geeigneter Verbindungen für die Nickelkationen und Phosphinationen. Darüber hinaus ist dem Fachmann auch bekannt, welche Additive, Stabilisatoren, Komplexbildner oder sonstige Zusätze noch für eine entsprechende Nickellegierung erforderlich sind.
Diese Parameter sind jedoch für die Anwendung des erfindungsgemäßen Verfahrens nicht kritisch. Deshalb wird nicht im einzelnen auf dieses Grundwissen eingegangen sondern es wird vielmehr auf das Lehrbuch "Funktionelle Galvanotechnik" von Wolfgang Riedel, E. Leuze Verlag, verwiesen.

Die Summe der Anteile der zuvor beschriebenen, im Elektrolyten enthaltenden Komponenten beträgt üblicherweise 100 Gew.-%.

Gemäß einer besonders bevorzugten Ausführungsform des erfindungsgemäßen Verfahrens handelt es sich um ein kontinuierliches Verfahren, bei dem dem wäßrigen Elektrolyten zur Beibehaltung der gewünschten Konzentration der jeweiligen Komponenten im wäßrigen Elektrolyten mindestens
i. eine die Nickelkationen und Bismutionen enthaltende Lösung (I); und
ii. eine die Phosphinationen und Antimonionen enthaltende Lösung (II)
zugesetzt werden.
Zur Stabilisierung des pH-Wertes wird dem wässrigen Elektrolyten eine Base in Form einer Lösung (III) zugesetzt, die insbesondere Ammoniak und/oder ein Alkalicarbonat, insbesondere Natriumcarbonat, enthält.
Die Beibehaltung der gewünschten Konzentrationen bzw. des pH-Wertes erfolgt durch dem Fachmann an sich bekannter, üblicher Verfahren, wie z.B. durch Verwendung von Dosierpumpen.

Als geeignete Bismutverbindung kann jede Verbindung genommen werden, die unter den Verfahrensbedingungen zur außen stromlosen Abscheidung eine ausreichende Konzentration an Bismutionen bereitstellt.
Als besonders vorteilhaft haben sich Verbindungen von Bismut herausgestellt, erhältlich aus der Umsetzung von Bismutoxycarbonat (BiO)₂CO₃ mit Phosphonsäure, Diphosphonsäure und/oder Sulfoncarbonsäuren mit 1 bis 6 Kohlenstoffatomen.

Als Antimonverbindung kann jede Substanz verwendet werden, die unter den Verfahrensbedingungen eine ausreichende Konzentration an Antimonkationen bereitstellt.

Besonders bevorzugt sind solche Verbindungen, erhältlich durch Umsetzen einer wasserlöslichen Antimon(III)-verbindung mit einer aliphatischen verzweigten oder unverzweigten Carbon- oder Hydrocarbonsäure mit 2 bis 8 Kohlenstoffatomen.

Die Erfindung betrifft des weiteren Gegenstände, die mit dem zuvor beschriebenen erfindungsgemäßen Verfahren mit einer Chemisch-Nickel-Schicht überzogen wurden, insbesondere Leiterplatten in der Elektronikindustrie.

Das folgende Beispiel dient der Erläuterung der Erfindung:

### Beispiel:

In einem 1-l Becherglas werden 500 ml vollentsalztes Wasser vorgelegt und unter Rühren folgende Verbindungen hinzugegeben:
30 g Nickelsulfat (NiSO₄ * 6 H₂O
35 g Natriumphosphinat (NaH₂PO₂ * H₂O)
30 g Malonsäure (CH₂(COOH)₂)
30 g Bernsteinsäure (HOOCCH₂CH₂COOH)
2 g Toluol-4-sulfonsäureamid (H₃C-C₆H₄-S(O)₂NH₂)
0,5 mg Bismutmethansulfonat (Bi(OS(O)₂CH₃)₃)

Anschließend werden 10 ml einer wässrigen Lösung hinzugegeben, die 1,5 g/l Antimonfluorid, 10 ml/l Borfluorwasserstoffsäure 50 %ig (HBF₄) und 100 mg/l Allylthioharnstoff enthält.
Danach wird der pH-Wert durch Zugabe einer 25 %igen wässrigen Ammoniaklösung auf den Wert 4,3 eingestellt und die Lösung durch Zugabe von vollentsalztem Wasser auf 1.000 ml aufgefüllt.

Nach Aufheizen auf 88 °C werden 1 mm dicke Stahlbleche der Legierung St 37 mit den Abmessungen 50 * 50 mm nach üblicher Vorbehandlung (Entfettung, Spülen, Aktivieren, Spülen) 60 Minuten lang in das Bad eingehängt.

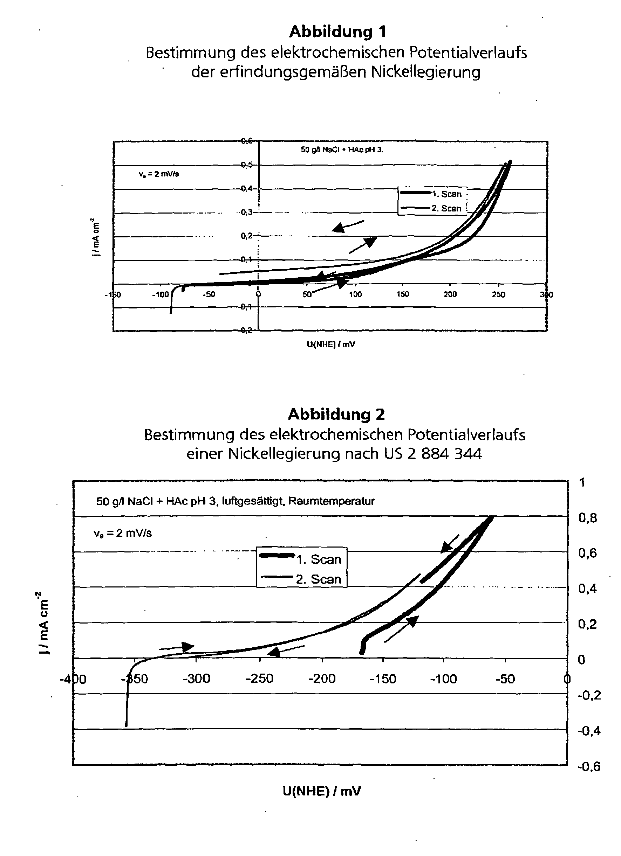

Danach wird das Blech gespült und getrocknet. Die erzielte Schichtdicke beträgt 12 µm.
Nach der zuvor beschriebenen Beschichtung wird der Elektrolyt für weitere acht Stunden auf Arbeitstemperatur (88 °C) gehalten. Eine Zersetzung ist nicht zu beobachten. Die Korrosionsbeständigkeit wird entsprechend den Vorschriften gemäß der DIN 50 018 KFW 0,2 S (Kesternich-Test) bestimmt.
Des weiteren wurde das elektrochemische Potential der resultierenden Nickellegierung gegen die Normalwasserstoffelektrode bestimmt. Wie aus der **Abbildung 1** ersichtlich, weist die erfindungsgemäße Nickellegierung ein positives Potential auf.
Darüber hinaus wird die innere Spannung einer so hergestellten Nickellegierung (Zugeigenspannung) mit einem Spiralkontraktometer nach Brenner/Senderoff bestimmt (A.Brenner, S.Senderoff, Proc. Amer. Electropol. Soc. **35** (1948) S.53).
Zur Bestimmung der in der Schicht enthaltenen Anteile wird die abgeschiedene Schicht in konzentrierter HNO₃ gelöst und die einzelnen Elemente per Atomabsorptionsspektroskopie bestimmt.

Die Ergebnisse der Untersuchungen sind in der nachfolgenden Tabelle aufgeführt.

### Vergleichsbeipiel 1:

In einem 1-I Becherglas werden 500 ml vollentsalztes Wasser vorgelegt und unter Rühren folgende Verbindungen hinzugegeben:
30 g Nickelsulfat (NiSO₄ * 6 H₂O)
35 g Natriumphosphinat (NaH₂PO₂ * H₂O)
30 g Malonsäure (CH₂(COOH)₂)
30 g Bernsteinsäure (HOOCCH₂CH₂COOH)
2 g Toluol-4-sulfonsäureamid (H₃C-C₆H₄-S(O)₂NH₂)
2 mg Bleiacetat (PB(CH₃COO)₂)
1 mg Allylthioharnstoff

Danach wird der pH-Wert durch Zugabe einer 25 %igen wässrigen Ammoniaklösung auf den Wert 4,3 eingestellt und die Lösung durch Zugabe von vollentsalztem Wasser auf 1.000 ml aufgefüllt.
Nach Aufheizen auf 88 °C werden 1 mm dicke Stahlbleche der Legierung St 37 mit den Abmessungen 50 * 50 mm nach üblicher Vorbehandlung (Entfettung, Spülen, Aktivieren, Spülen) 60 Minuten lang in das Bad eingehängt.
Danach wird das Blech gespült und getrocknet. Die erzielte Schichtdicke beträgt 12 µm.

Nach der zuvor beschriebenen Beschichtung wird der Elektrolyt weiter auf Arbeitstemperatur (88 °C) gehalten. Eine beginnende Zersetzung ist bereits nach einer Stunde zu beobachten. Nach drei Stunden ist eine nahezu vollständige Zersetzung des Elektrolyten zu beobachten.

Darüber hinaus wird die innere Spannung einer so hergestellten Nickellegierung (Zugeigenspannung) mit einem Spiralkontraktometer nach Brenner/Senderoff bestimmt (A.Brenner, S.Senderoff, Proc. Amer. Electropol. Soc. **35** (1948) S.53).
Zur Bestimmung der in der Schicht enthaltenen Anteile wird die abgeschiedene Schicht in konzentrierter HNO₃ gelöst und die einzelnen Elemente per Atomabsorptionsspektroskopie bestimmt.

Die Ergebnisse der Untersuchungen sind in der nachfolgenden Tabelle aufgeführt.

### Vergleichsbeipiel 2 (nach US 2 884 344):

Entsprechend der US 2 884 344 werden in einem 1-I Becherglas werden 500 ml vollentsalztes Wasser vorgelegt und unter Rühren folgende Verbindungen hinzugegeben:
25 g Nickelsulfat (NiSO₄ * 7 H₂O)
23 g Natriumphosphinat (NaH₂PO₂ * H₂O)
8 g Natriumcitrat
1 g Natriumtartrat
8 g Natriumacetat
3,7 mg Antimon(III)chlorid
15,0 mg Bismut(III)chlorid

Danach wird die Lösung durch Zugabe von vollentsalztem Wasser auf 1.000 ml aufgefüllt. Der pH-Wert der Lösung beträgt 5,1.
Nach Aufheizen auf 95 °C werden 1 mm dicke Stahlbleche der Legierung St 37 mit den Abmessungen 50 * 50 mm nach üblicher Vorbehandlung (Entfettung, Spülen, Aktivieren, Spülen) 60 Minuten lang in das Bad eingehängt.
Danach wird das Blech gespült und getrocknet. Die erzielte Schichtdicke beträgt 13 µm.

Die Korrosionsbeständigkeit wird entsprechend den Vorschriften gemäß der DIN 50 018 KFW 0,2 S (Kesternich-Test) bestimmt.
Des weiteren wurde das elektrochemische Potential der resultierenden Nickellegierung gegen die Normalwasserstoffelektrode bestimmt. Wie aus der **Abbildung 2** ersichtlich, weist diese Nickellegierung ein negativen Potentialverlauf auf.
Darüber hinaus wird die innere Spannung einer so hergestellten Nickellegierung (Zugeigenspannung) mit einem Spiralkontraktometer nach Brenner/Senderoff bestimmt (A.Brenner, S.Senderoff, Proc. Amer. Electropol, Soc. **35** (1948) S.53).
Zur Bestimmung der in der Schicht enthaltenen Anteile wird die abgeschiedene Schicht in konzentrierter HNO₃ gelöst und die einzelnen Elemente per Atomabsorptionsspektroskopie bestimmt.

Die Ergebnisse der Untersuchungen sind in der nachfolgenden Tabelle aufgeführt.

**Tabelle**

| | Beispiel | Vergleichsbeispiel 1 | Vergleichsbeispiel 2 |
|---|---|---|---|
| Korrosionsbeständigkeit (in Zyklen) | 2 | 1 | 0 |
| Innere Spannung (in N/mm²) | -30 | -10 | +50 |
| Ni-Gehalt* | 86,5 | 87,8 | 91,5 |
| P-Gehalt* | 12,1 | 12,0 | 7,5 |
| Bi-Gehalt* | 0,1 | 0 | 0,7 |
| Sb-Gehalt* | 1,3 | 0 | < 0,05 |
| Pb-Gehalt* | 0 | 0,2 | 0 |

| | | | |
|---|---|---|---|
| * in Gew-%, bezogen auf alle in der Nickellegierung enthaltenen Elemente | | | |

Die Tabelle zeigt deutlich verbesserte Eigenschaften der erfindungsgemäßen Nickellegierung gegenüber den Nickelschichten des Standes der Technik.

## Patentansprüche

1. Auf einer metallischen Substratoberfläche befindliche bleifreie Nickellegierung, enthaltend
• Nickel,
• Phosphor,
• Bismut mit einem Anteil von höchstens 0,4 Gew.-%, und
• Antimon mit einem Anteil von mindestens 1 Gew.-%,
bezogen auf alle Bestandteile der Nickellegierung.

2. Nickellegierung nach Anspruch 1, **dadurch gekennzeichnet, daß** der Anteil an Phosphor zwischen 2 und 15 Gew.-% aller Bestandteile der Nickellegierung liegt.

3. Nickellegierung nach Anspruch 1 oder 2, **dadurch gekennzeichnet, daß** der Anteil an Bismut zwischen 0,01 und 0,2 Gew.-% aller Bestandteile der Nickellegierung liegt.

4. Nickellegierung nach einem der vorhergehenden Ansprüche, **dadurch gekennzeichnet, daß** der Anteil an Antimon zwischen 1 und 3 Gew.-% aller Bestandteile der Nickellegierung liegt.

5. Nickellegierung nach einem der vorhergehenden Ansprüche, **dadurch gekennzeichnet, daß** die Bestandteile Nickel, Phosphor, Bismut und Antimon gleichmäßig in der Nickellegierung verteilt sind.

6. Verfahren zur Herstellung einer bleifreien Nickellegierung nach einem der vorherghenden Ansprüche, **dadurch gekennzeichnet, dass** ein metallisches Substrat in einen wäßrigen Elektrolyten getaucht wird, der Nickelkationen, Phosphinationen, Bismutionen in einer Konzentration an Bismut von höchstens 0,3 ppm und Antimonionen in einer Konzentration an Antimon von mindestens 10 ppm enthält.

7. Verfahren nach Anspruch 6, **dadurch gekennzeichnet, daß** die Anteile der im Elektrolyten enthaltenen Bestandteile zusammen 100 Gew.-% betragen.

8. Verfahren nach Anspruch 6 oder 7, **dadurch gekennzeichnet, daß** es ein kontinuierliches Verfahren ist, bei dem dem wäßrigen Elektrolyten zur Beibehaltung der gewünschten Konzentration der jeweiligen Komponenten im wäßrigen Elektrolyten mindestens
i. eine die Nickelkationen und Bismutionen enthaltende Lösung (I); und
ii. eine die Phosphinationen und Antimonionen enthaltende Lösung (II)
zugesetzt werden.

9. Verfahren nach einem der Ansprüche 6 oder 8, **dadurch gekennzeichnet, daß** dem wäßrigen Elektrolyten eine zusätzliche Lösung (III), enthaltend Ammoniak und/oder Alkalicarbonat, insbesondere Natriumcarbonat, zugesetzt wird.

10. Verfahren nach einem der Ansprüche 6 bis 9, **dadurch gekennzeichnet, daß** die Bismutionen aus einer Verbindung stammen, erhältlich aus der Umsetzung von Bismutoxycarbonat (BiO)₂CO₃ mit Phosphonsäure, Diphosphonsäure und/oder Sulfoncarbonsäuren mit 1 bis 6 Kohlenstoffatomen.

11. Verfahren nach einem der Ansprüche 6 bis 10, **dadurch gekennzeichnet, dass** die Antimonionen aus einer Verbindung stammen, erhältlich durch Umsetzung einer wasserlöslichen Antimon(III)-verbindung mit einer aliphatischen verzweigten oder unverzweigten Carbon- oder Hydrocarbonsäure mit 2 bis 8 Kohlenstoffatomen.

12. Gegenstand mit einer Nickellegierung, erhältlich nach einem der Ansprüche 6 bis 11.

13. Gegenstand nach Anspruch 12, **dadurch gekennzeichnet, daß** er eine Leiterplatte für die Elektronikindustrie ist.

## Claims

1. Lead-free nickel alloy present on a metallic substrate surface, the alloy containing
• nickel
• phosphorus
• bismuth in a proportion of maximum 0.4 % by wt. and
• antimony in a proportion of minimum 1 % by wt.
based on all the components of the nickel alloy.

2. Nickel alloy according to claim 1 **characterised in that** the proportion of phosphorus is between 2 and 15 % by wt. of all the components of the nickel alloy.

3. Nickel alloy according to claim 1 or 2 **characterised in that** the proportion of bismuth is between 0.01 and 0.2 % by wt. of all the components of the nickel alloy.

4. Nickel alloy according to one of the preceding claims **characterised in that** the proportion of antimony is between 1 and 3 % by wt. of all the components of the nickel alloy.

5. Nickel alloy according to one of the preceding claims **characterised in that** the components of nickel, phosphorus, bismuth and antimony are evenly distributed in the nickel alloy.

6. Process for the production of a lead-free nickel alloy according to one of the preceding claims **characterised in that** a metallic substrate is dipped into an aqueous electrolyte containing nickel cations, phosphinate ions, bismuth ions in a concentration of bismuth of maximum 0.3 ppm and antimony ions in a concentration of antimony of at least 10 ppm.

7. Process according to claim 6 **characterised in that** the proportion of the components contained in the electrolyte are 100 % by wt. in total.

8. Process according to claim 6 or 7 **characterised in that** it is a continuous process in which at least
i. a solution (I) containing the nickel cations and bismuth ions and
ii. a solution (II) containing the phosphinate ions and antimony ions
are added to the aqueous electrolyte in order to maintain the desired concentration of components concerned in the aqueous electrolyte.

9. Process according to one of claims 6 or 8 **characterised in that** an additional solution (III) containing ammonia and/or alkali carbonate, in particular sodium carbonate, is added to the aqueous electrolyte.

10. Process according to one of claims 6 or 8 **characterised in that** the bismuth ions originate from a compound obtainable from the conversion of bismuth oxycarbonate (BiO)₂CO₃ with phosphonic acid, diphosphonic acid and/or sulphocarboxylic acids with 1 to 6 carbon atoms.

11. Process according to one of claims 6 or 10 **characterised in that** the antimony ions originate from a compound obtainable by the conversion of a watersoluble antimony (III) compound with an aliphatic branched or unbranched carboxylic or hydrocarboxylic acid with 2 to 8 carbon atoms.

12. Object with a nickel alloy obtainable according to one of claims 6 to 11.

13. Object according to claim 12 **characterised in that** it is a printed-circuit board for the electronics industry.

## Revendications

1. Alliage de nickel sans plomb se trouvant sur une surface de support métallique, composé
• de nickel,
• de phosphore,
• de bismuth dans une teneur maximale de 0,4 % en poids et
• d'antimoine dans une teneur maximale de 1 % en poids,
par rapport à tous les composants de l'alliage de nickel.

2. Alliage de nickel selon la revendication 1, **caractérisé en ce que** la teneur en phosphore est comprise entre 2 et 15 % en poids de tous les composants de l'alliage de nickel.

3. Alliage de nickel selon l'une des revendications 1 ou 2, **caractérisé en ce que** la teneur en bismuth est comprise entre 0,01 et 0,2 % en poids de tous les composants de l'alliage de nickel.

4. Alliage de nickel selon l'une des revendications précédentes, **caractérisé en ce que** la teneur en antimoine est comprise entre 1 et 3 % en poids de tous les composants de l'alliage de nickel.

5. Alliage de nickel selon l'une des revendications précédentes, **caractérisé en ce que** les composants nickel, phosphore, bismuth et antimoine sont régulièrement répartis dans l'alliage de nickel.

6. Procédé de fabrication d'un alliage de nickel sans plomb selon l'une des revendications précédentes, **caractérisé en ce qu'**un support métallique est plongé dans un électrolyte aqueux contenant des cations de nickel, des ions de phosphinate, des ions de bismuth dans une concentration maximale de bismuth de 0,3 ppm et d'antimoine dans une concentration minimale de 10 ppm.

7. Procédé selon la revendication 6, **caractérisé en ce que** les taux des composants contenus dans l'électrolyte s'élèvent en tout à 100 % en poids.

8. Procédé selon l'une des revendications 6 ou 7, **caractérisé en ce qu'**il s'agit d'un procédé en continu, dans lequel en vue de maintenir la concentration souhaitée des composants respectifs dans l'électrolyte aqueux, on ajoute à l'électrolyte aqueux au moins
i. une solution (I) contenant les cations de nickel et les ions de bismuth ; et
ii. une solution (II) contenant les ions de phosphinate et les ions d'antimoine.

9. Procédé selon l'une des revendications 6 ou 8, **caractérisé en ce que** l'on ajoute à l'électrolyte aqueux une solution supplémentaire (III) contenant de l'ammoniac et/ou du carbonate alcalin, en particulier du carbonate de sodium.

10. Procédé selon l'une des revendications 6 à 9, **caractérisé en ce que** les ions de bismuth proviennent d'un composé pouvant être obtenu à partir de la réaction de l'oxycarbonate de bismuth (BiO)₂CO₃, avec l'acide phosphonique, l'acide diphosphonique et/ou les acides sulfocarboniques ayant 1 à 6 atomes de carbone.

11. Procédé selon l'une des revendications 6 à 10, **caractérisé en ce que** les antimoines proviennent d'un composé pouvant être obtenu à partir de la réaction d'un composé antimonieux (III) soluble dans l'eau avec un acide carbonique ou un acide hydrocarbonique aliphatique ramifié ou linéaire ayant 2 à 8 atomes de carbone.

12. Objet avec un alliage de nickel, pouvant être obtenu d'après l'une des revendications 6 à 11.

13. Objet selon la revendication 12, **caractérisé en qu'**il s'agit d'une plaquette à circuit imprimé pour l'industrie de l'électronique.
